# EUROPÄISCHE PATENTANMELDUNG

(11) **EP 3 473 864 A1**
(43) Veröffentlichungstag der Anmeldung: **24.04.2019**
(21) Anmeldenummer: 17197494.2
(22) Anmeldetag: 20.10.2017
(51) Int. Cl.: F15B 7/08

(54) **AKTORVORRICHTUNG**

(71) Anmelder: Siemens Aktiengesellschaft, 80333 München (DE)
(72) Erfinder: Bachmaier, Georg, 80469 München (DE); Fröse, Patrick, 80539 München (DE); Zöls, Wolfgang, 81249 München-Lochhausen (DE)

(57) **Zusammenfassung**

Die Erfindung betrifft eine Aktorvorrichtung (1), aufweisend a. einen Polymeraktor (10), b. ein Element (20), wobei c. der Polymeraktor (20) mit dem Element (20) bewegungsgekoppelt ist, wobei d. das Element (20) zur Übersetzung einer Kraft (12) oder einer anderen Größe, oder Aufintegrieren mindestens zweier Bewegungen eingerichtet ist.

## Beschreibung

### 1. Technisches Gebiet

Die Erfindung betrifft eine Aktorvorrichtung. Die Erfindung kann in der Robotik im Rahmen eines industriellen Umfelds, wie der Industrie 4.0, oder in dem technischen Bereich der Automatisierungstechnik eingesetzt werden.

### 2. Stand der Technik

Aktoren sind in vielfältiger Zahl aus dem Stand der Technik bekannt. Sie setzen üblicherweise ein elektrisches Signal in eine mechanische Bewegung oder eine andere physikalische Größe um. Mit anderen Worten, werden Aktoren für die Umsetzung eines Signals eingesetzt. Dementsprechend können sie auch als Signalwandler bezeichnet werden. Ferner sind sie unter den Begriffen Aktuatoren und Antriebselemente bekannt. Sie werden beispielsweise in den technischen Bereichen der Mess-, Steuerungs- und Regelungstechnik, Robotik und Mechatronik eingesetzt. In diesen Bereichen werden sie beispielsweise für bestimmte Justieraufgaben eingesetzt, mit deren Hilfe präzise Einstellungen vorgenommen werden können.

Ferner gibt es unterschiedliche Typen oder Arten der Aktoren, wie Piezoaktoren. Bei einem Piezoaktor wird herkömmlicherweise durch den Piezoeffekt bei Anlegen einer äußeren Spannung als elektrisches Signal aufgrund einer entstehenden Änderung der elektrischen Polarisation im Piezo eine Verformung des Piezoaktors induziert.

Die Aktoren sind üblicherweise steif ausgebildet, um eine effiziente Kraftübertragung zu gewährleisten. Die Piezoaktoren sind üblicherweise sehr steif ausgebildet. Nachteilig an deren Steifigkeit ist jedoch die geringe oder fehlende Nachgiebigkeit. Dadurch können erwünschte Bewegungen nicht hinreichend weich genug ausgeführt werden, beispielsweise Bewegungen einer Robotereinheit im Bereich der Robotik.

Insbesondere hinsichtlich der "Industrie 4.0" wird zum Beispiel eine größere Flexibilität der konventionellen maschinellen Automation angestrebt. Das so genannte "Soft Robotics", bei dem Robotereinheiten in der Fertigung direkt mit Menschen zusammenarbeiten sollen, gewinnt zunehmend an Bedeutung. Voraussetzung hierfür sind Aktoren, welche eine geminderte Steifigkeit und eine geringe Masse aufweisen. Gleichzeitig soll die Funktion der Aktoren nicht eingeschränkt werden. Daher werden bei vielen Aktoranwendungen unterschiedliche Arbeitspunkte, in denen entweder eine hohe Kraft oder eine hohe Geschwindigkeit erforderlich ist, angestrebt. Ferner soll das Einstellen eines solchen Geschwindigkeits- oder Kraftmodus durch die variable Steifigkeit der Sensoren nicht negativ beeinflusst werden.

Derzeit werden in diesem und anderen Bereichen vorwiegend Piezoaktoren eingesetzt, da sie ein gutes Ansprechverhalten aufweisen. Bisher werden üblicherweise in die Piezoaktoren die Steifigkeit reduzierende Elemente, wie beispielsweise Federn, eingefügt, um die Nachgiebigkeit zu verbessern. Das Hinzufügen weiterer Komponenten hat sich jedoch als nachteilig erwiesen, da die Komplexität der Piezoaktoren deutlich erhöht wird.

Als zusätzliche Nachteile sind die erhöhten Kosten und das erhöhte Gewicht zu nennen. Insbesondere weisen Materialien, wie Piezokeramiken und Metalle ein hohes Gewicht auf. Darüber hinaus ergibt sich der Nachteil, dass einerseits die für die Leistungsanpassung geforderte und gegebene hohe Systemsteifigkeit des Piezoaktors benötigt und andererseits diese hohe Steifigkeit wiederrum durch weitere Elemente reduziert wird. Die Piezoaktoren und die übergeordneten Aktorvorrichtungen sind daher ineffizient. Darüber hinaus ist der Herstellungsprozess der Piezoaktoren aufwendig. Die einzelnen Komponenten der Piezoaktoren müssen mit mehreren Schweißnähten verbunden werden oder können verschraubt werden, um eine mechanische Verbindung zu realisieren.

Es ist daher Aufgabe der vorliegenden Erfindung eine Aktorvorrichtung zur Erzeugung einer Bewegung bereitzustellen, welche in effizienter und kostengünstiger Weise ein weiches Bewegungsverhalten ermöglicht und die oben genannten Nachteile beseitigt.

### 3. Zusammenfassung der Erfindung

Die oben genannte Aufgabe wird erfindungsgemäß durch eine Aktorvorrichtung gelöst, aufweisend:
a. einen Polymeraktor,
b. ein Element, wobei
c. der Polymeraktor mit dem Element bewegungsgekoppelt ist, wobei
d. das Element
   - zur Übersetzung einer Kraft oder einer anderen Größe, oder
   - Aufintegrieren mindestens zweier Bewegungen eingerichtet ist.

Dementsprechend ist die erfindungsgemäße Aktorvorrichtung auf die Erzeugung einer Bewegung gerichtet. Die Bewegung kann eine mechanische Bewegung sein, beispielsweise eine lineare Bewegung.

Die Aktorvorrichtung weist einen Polymeraktor auf. Ein Polymeraktor ist ein Aktor, der zumindest teilweise aus einem Polymer besteht. Dabei ist das Polymer insbesondere ein elektroaktives Polymer. Das elektroaktive Polymer erfährt bei Aufbringen eines elektrischen Signals eine Änderung in der Form oder der Größe. Das elektrische Signal kann beispielsweise durch das Anlegen einer elektrischen Spannung realisiert werden.

Ferner weist die Aktorvorrichtung ein Element auf. Das Element kann als ein Integrator oder ein Übersetzer ausgebildet sein. Die beiden Komponenten, der Polymeraktor und das Element, sind bewegungsgekoppelt. Die Bewegungskopplung kann beispielsweise durch eine tatsächlich bestehende physische Verbindung beider Komponenten realisiert werden, zum Beispiel mit einer Welle oder durch ein Fluid. Alternativ kann die Bewegungskopplung auch durch das Ausüben einer Bewegung des Polymeraktors oder des Elements realisiert werden.

Das Element kann eine Kraft übersetzen oder auch eine andere Größe, wie einen Weg oder eine Geschwindigkeit über- untersetzen. Daher kann das Element als Übersetzer eingesetzt werden. Das Element kann alternativ auch zum aufintegrieren einzelner Bewegungen in eine kontinuierliche längere Bewegung verwendet werden. Mit anderen Worten, werden die Bewegungen dadurch aufsummiert. Daher kann das Element als Integrator eingesetzt werden.

Die Verwendung des Polymeraktors weist mehrere Vorteile auf. Die Polymeraktoren können Volumenänderungen erreichen, welche zur Bewegungserzeugung genutzt werden. Die Ausdehnungen liegen weitaus höher als bei herkömmlichen piezoelektrischen Keramiken.

Darüber hinaus sind die Polymeraktoren naturgemäß weniger steif, leichter und günstiger im Vergleich zu herkömmlichen Piezoaktoren. Dadurch ist eine Verringerung der Steifigkeit über hinzuzufügende Komponenten im Gegenteil zum Stand der Technik nicht notwendig. Mit anderen Worten, werden keine zusätzlichen Komponenten zur Verringerung der Nachgiebigkeit benötigt.

Ferner sind die Ansteuerfrequenzen für die Polymeraktoren geringer und die Akustik besser im Vergleich zu herkömmlichen Piezoaktoren. Durch die Verwendung der weniger steifen Materialen oder die geringere Steifigkeit der Polymeraktoren, sind die Schwingungen am Außenbereich des Aktors für den Menschen vorteilhafterweise weniger wahrnehmbar.

Darüber hinaus weisen die Polymeraktoren eine gute Dynamik auf und können hohe Reaktionsgeschwindigkeiten bei gleichzeitig hoher Genauigkeit realisieren vergleichbar mit den menschlichen Muskeln. Dies resultiert wiederum in einer Gewichts-, Kosten- und Komplexitätsreduktion der Aktorvorrichtung.

In einer Ausgestaltung der Erfindung ist das Element der Aktorvorrichtung hydraulisch ausgebildet. Dementsprechend ist das Element ein hydraulisches Element. Die hydraulische Übertragung hat sich hinsichtlich einer präzisen Erzeugung der Bewegung und Justierung als besonders vorteilhaft erwiesen.

In einer weiteren Ausgestaltung der Erfindung weist das Element der Aktorvorrichtung mindestens eine erste Kammer und mindestens eine zweite Kammer auf. Die erste und die zweite Kammer sind jeweils mindestens zum Teil mit einem hydraulischen Arbeitsfluid miteinander gekoppelt. Die Kopplung ist beispielsweise über hydraulische Elemente, wie Rückschlagventile oder Leitungen realisiert. Der Polymeraktor ist zum Ausüben der Kraft auf die mindestens eine erste Kammer ausgebildet.

In einer weiteren Ausgestaltung der Erfindung ist die mindestens eine erste Kammer des Elements als ein Antriebszylinder eingerichtet. Der Antriebszylinder weist ein erstes Kolbenelement und einen ersten Arbeitsraum auf. Ein erstes Volumen des ersten Arbeitsraums ist durch Bewegen des mindestens einen ersten Kolbenelementes änderbar. Die mindestens eine zweite Kammer ist als ein Abtriebszylinder eingerichtet. Der Abtriebszylinder weist ein zweites Kolbenelement zum Erzeugen der Bewegung und einen zweiten Arbeitsraum auf. Ein zweites Volumen des zweiten Arbeitsraums ist durch Bewegen des mindestens einen zweiten Kolbenelementes änderbar. Der Polymeraktor ist zum Ausüben der Kraft auf die mindestens eine erste Kammer ausgebildet. Dementsprechend wird durch die Bewegungskopplung des Polymeraktors mit dem Element die Kraft des Polymeraktors auf das erste Kolbenelement des Antriebszylinders übertragen. Infolgedessen bewegt sich das erste Kolbenelement und verändert das Volumen des ersten Arbeitsraums. Durch die Kopplung der Kammern erfährt auch das Volumen des zweiten Arbeitsraums eine entsprechende Änderung, wodurch sich das zweite Kolbenelement bewegt. Insbesondere können die beiden Kolbenelemente derart ausgestaltet werden, dass die Kraft, die der Polymeraktor aufbringt, mit einer vorgegebenen Übersetzung übertragen wird. Hierdurch eignet sich die Aktorvorrichtung insbesondere für hochpräzise Justiervorgänge und dergleichen. Alternativ zu den Kolben und Zylindern kann auch ein ausdehnbares Volumen, wie Balgelemente oder Membranen verwendet werden.

In einer weiteren Ausgestaltung der Erfindung sind der mindestens eine erste und der mindestens eine zweite Arbeitsraum über mindestens ein erstes Rückschlagventil verbunden. Dies ermöglicht das Einstellen der fluidischen Kopplung in nur eine Richtung. Beispielsweise wird ein Rückschlagventil verwendet, das nur den Durchfluss oder die Strömung des hydraulischen Arbeitsfluids als Medium von der mindestens einen ersten Kammer in die mindestens eine zweite Kammer ermöglicht oder umgekehrt.

In einer weiteren Ausgestaltung der Erfindung sind der erste und der zweite Arbeitsraum über zwei Rückschlagventile verbunden, wobei ein Rückschlagventil gegenläufig zu dem anderen Rückschlagventil ausgerichtet ist. Dementsprechend wird ein gesteuertes Übertreten des verwendeten hydraulischen Arbeitsfluids zwischen den Arbeitsräumen ermöglicht. Es ist dabei besonders zweckmäßig, dass bei beiden Rückschlagventile ein von den Steifigkeiten (z.B. Balg), hydraulischen Querschnitten und max. Auslenkung abhängige Öffnungsdrücke verwendet werden.

In einer weiteren Ausgestaltung der Erfindung ist der erste Arbeitsraum des ersten Kolbenelements über eine erste Drossel oder ein Ventil mit einem Reservoir für das hydraulische Arbeitsfluid des Elements gekoppelt. Dementsprechend ergibt sich die folgende Möglichkeit zum Erzeugen von Linearbewegungen, die über den Bewegungsspielraum des Polymeraktors selbst hinaus gehen. Außerdem kann auf diese Weise hydraulisches Arbeitsfluid aus dem Reservoir gespeist oder das Reservoir entleert werden.

In einer ersten Bewegungsphase wird der Polymeraktor derart angesteuert, dass er eine schnelle Bewegung erzeugt. Die schnelle Bewegung wird auf das erste Kolbenelement übertragen und erzeugt einen Druck im Arbeitsfluid, der hinreichend ist, um das Ventil zwischen den Arbeitsräumen in Richtung auf den zweiten Arbeitsraum hin zu öffnen. Flüssigkeit strömt nun in den zweiten Arbeitsraum über und bewegt dort das zweite Kolbenelement, welches die gewünschte Vorwärtsbewegung erzeugt.

In einer zweiten Bewegungsphase wird der Polymeraktor langsam entgegen der Richtung, in der es in der ersten Bewegungsphase bewegt wurde, bewegt. Hierdurch wird zwar das erste Kolbenelement ebenfalls in Gegenrichtung zurückgezogen, durch die langsame Bewegung öffnet sich jedoch nicht das vom zweiten zum ersten Arbeitsraum gerichtete Rückschlagventil. Die entsprechende Volumenänderung im ersten Arbeitsraum wird vielmehr vom Reservoir durch das Drosselelement ausgeglichen. Der Polymeraktor und das erste Kolbenelement sind somit wieder in ihre Ausgangsposition zurückgestellt, während das zweite Kolbenelement in seiner Position bleibt.

Durch Wiederholen der beiden Phasen in alternierender Weise kann ein beliebig weiter Vorschub des zweiten Kolbenelements erzielt werden, der den eigentlichen Bewegungsspielraum des Polymeraktors überschreitet. Dies ermöglicht eine besonders präzise Platzierung des zweiten Kolbenelements über weite, beispielsweise lineare Bewegungspfade und bringt gleichzeitig den Vorteil mit sich, dass zum Halten einer vorgegebenen Position des zweiten Kolbenelements keine Energie aufwendet werden muss. Ferner ist der Bewegungsablauf unabhängig von der Haftreibung der beteiligten Komponenten und wird daher nicht von Verschmutzung, Öleintrag oder dergleichen beeinträchtigt.

Die Arbeitsräume können hierbei beispielsweise durch jeweilige Zylindern gebildet werden, in welchen die Kolbenelemente beweglich aufgenommen sind. Eine Alternative hierzu stellt die Ausbildung der Arbeitsräume durch jeweilige Faltenbälge oder Membranen dar, die mit den Kolbenelementen gekoppelt sind. In dieser Ausführungsform sind alle wesentlichen beweglichen Teile der Aktorvorrichtung gekapselt und damit vor Verschmutzung geschützt, so dass sich ein langfristig zuverlässiger und verschleißarmer Betrieb der Vorrichtung ergibt.

In einer weiteren Ausgestaltung der Erfindung der Aktorvorrichtung weist das Element weiterhin ein Druckbegrenzungsventil auf, welches dazu eingerichtet abhängig von einer Einwirkzeit der Kraft auf den Antriebszylinder und/oder auf das erste Kolbenelement den Abtriebszylinder druckzubegrenzen. Dementsprechend lässt sich mittels der Einwirkzeit der Kraft auf den Antriebskolben das Druckbegrenzungsventil steuern. Das Druckbegrenzungsventil, welches den Abtriebszylinder druckbegrenzt, stellt aufgrund dieser Druckbegrenzung die Impedanz des Polymeraktors ein. Mittels der Einwirkzeit der Kraft auf den Antriebskolben kann folglich die Impedanz entsprechend eingestellt werden.

In einer weiteren Ausgestaltung der Erfindung ist der erste Arbeitsraum des Antriebszylinders über mindestens ein drittes Rückschlagventil und eine zweite Drossel hydraulisch an ein Vorspannvolumen gekoppelt, welches insbesondere in einem Vorspannhydraulikzylinder befindlich ist, wobei der Vorspannhydraulikzylinder oder der Vorspannkolben das Druckbegrenzungsventil stellt. Auf diese Weise lässt sich einfach mittels der Einwirkzeit der Kraft auf den Antriebskolben über das dritte Rückschlagventil und die zweite Drossel hydraulisch das Vorspannvolumen einstellen, welches mittels des Vorspannkolbens das Druckbegrenzungsventil geeignet stellt.

In einer weiteren Ausgestaltung der Erfindung ist das Vorspannvolumen über eine dritte Drossel hydraulisch mit dem Reservoir verbunden ist. Auf diese Weise lässt sich bei entsprechender Einwirkzeit das Vorspannvolumen in das Reservoir entleeren.

In einer weiteren Ausgestaltung der Erfindung ist das Druckbegrenzungsventil zur Druckbegrenzung gegenüber dem Reservoir oder zur Druckentlastung in dem Reservoir angeordnet. Auf diese Weise kann bei einer geringen Steifigkeit des Polymeraktors der Abtriebszylinder Druck in das Reservoir entlassen oder aber je nach Stellung des Druckbegrenzungsventils eine hohe Kraft und Impedanz behalten.

In einer weiteren Ausgestaltung der Erfindung ist die Aktorvorrichtung als ein Vier-Kammern-System ausgebildet. Die erste Kammer ist als ein von dem Polymeraktor bewegbarer, mit einem hydraulischen Arbeitsfluid gefüllter Antriebsbalg ausgebildet. Die zweite Kammer ist als ein Abtriebszylinder mit einem zweiten Kolbenelement und mit einem zweiten Arbeitsraum ausgeführt. Dabei ist der zweite Abtriebszylinder mit dem Antriebsbalg über ein erstes Rückschlagventil hydraulisch verbunden. Dies bildet einen ersten Abtrieb. Ein mit hydraulischem Arbeitsfluid gefüllter Abtriebsbalg bildet eine dritte Kammer. Die dritte Kammer ist mit dem zweiten Kolbenelement und dem Gehäuse mechanisch parallel gekoppelt. Durch die mechanische parallele Kopplung wird ein zweiter Abtrieb gebildet. Der Antriebsbalg ist außerdem über ein zweites Rückschlagventil hydraulisch mit einer vierten Kammer verbunden. Die vierte Kammer ist als ein mit dem hydraulischen Arbeitsfluid gefüllten Hydraulikreservoir ausgeführt. Das Hydraulikreservoir ist mit dem Abtriebsbalg über ein drittes Rückschlagventil hydraulisch verbunden. Außerdem ist der Abtriebszylinder mit dem Abtriebsbalg über ein viertes Rückschlagventil hydraulisch verbunden.

Der Balg kann auch alternativ ein sonstiges Arbeitsvolumen, Zylinder, Kolben oder Membran sein.

Antriebsbalg ist hier insbesondere ein eine Flüssigkeit beinhaltendes, insbesondere in Bewegungsrichtung, elastisches Reservoir, das derart eingerichtet ist, dass auf dieses Kraft aufbringbar ist. Abtriebsbalg ist hier insbesondere ein eine Flüssigkeit beinhaltendes, insbesondere in Bewegungsrichtung, elastisches Reservoir, das derart eingerichtet ist, dass aus diesem Kraft ausgebbar ist.

Diese Ausgestaltung der Aktorvorrichtung hat den Vorteil, dass mit diesem sowohl kraft- als auch geschwindigkeitsoptimiert ausgelenkt werden kann. Der Vorteil gegenüber vergleichbaren herkömmlichen Lösungen, die mit Getriebestufen arbeiten, ist, dass das beschriebene System automatisch zwischen Geschwindigkeits- und Kraftmodus wechseln kann. Insbesondere ist es möglich, zwischen den beiden Modi unterbrechungsfrei umzuschalten. Außerdem ist dieser Antrieb bei Verwendung von Kapselungen aufgrund der Verwendung von Bälgen für eine harsche Umgebung beispielsweise bei starken Vibrationen oder großen Verschmutzungen geeignet.

In einer weiteren Ausgestaltung der Erfindung ist der hydraulische Querschnitt des zweiten Kolbenelements kleiner als der hydraulische Querschnitt des Abtriebsbalgs und kleiner als der hydraulische Querschnitt des Antriebsbalgs. Der hydraulische Querschnitt eines Bauteils ist hier insbesondere die von dem Bauteil geschaffene Fläche, auf die eine für einen Druckaufbau notwendige Kraft senkrecht wirkt und die senkrecht zu einer Bewegungsrichtung orientiert ist. Durch die Gestaltung der Querschnitte gemäß dieser Ausgestaltung ist eine definierte Übersetzung von dem ersten Abtrieb zu dem Antrieb möglich. Der Vorteil liegt darin, dass eine automatische Umschaltung und eine muskelähnliche Kraft- Geschwindigkeitskennlinie ermöglicht wird. Dadurch ist wenig Leistung erforderlich.

In einer weiteren Ausgestaltung der Erfindung ist das vierte Rückschlagventil derart eingerichtet, dass es bei einem Druckanstieg im ersten Abtrieb infolge einer äußeren Gegenkraft derart öffnet, dass Hydraulikflüssigkeit zusätzlich zu dem zweiten Abtrieb befördert wird.

In einer weiteren Ausgestaltung der Erfindung sind die Ventile oder die Drosseln aus einem Polymer ausgebildet. Unter Ventilen und Drosseln sind insbesondere alle in den vorherigen Ausgestaltungen der Erfindung genannten Ventile, beispielsweise die Rückschlagventile, und Drosseln zu verstehen.

### 4. Kurze Beschreibung der Zeichnungen

In der folgenden detaillierten Beschreibung werden vorliegend bevorzugte Ausführungsformen der Erfindung weiter beschrieben mit Bezug auf die folgenden Figuren.
- FIG 1: zeigt eine schematische Darstellung einer erfindungsgemäßen Aktorvorrichtung.
- FIG 2: zeigt eine schematische Darstellung einer Aktorvorrichtung gemäß einer Ausführungsform der Erfindung.
- FIG 3: zeigt ein hydraulisches Ersatzschaltbild der Aktorvorrichtung gemäß Figur 2 gemäß einer Ausführungsform der Erfindung.
- FIG 4: zeigt ein weiteres hydraulisches Ersatzschaltbild der Aktorvorrichtung gemäß einer Ausführungsform der Erfindung.
- FIG 5: zeigt ein weiteres hydraulisches Ersatzschaltbild der Aktorvorrichtung gemäß einer Ausführungsform der Erfindung.

### 5. Beschreibung der bevorzugten Ausführungsformen

Im Folgenden werden bevorzugte Ausführungsformen der vorliegenden Erfindung in Bezug auf die Figuren beschrieben.

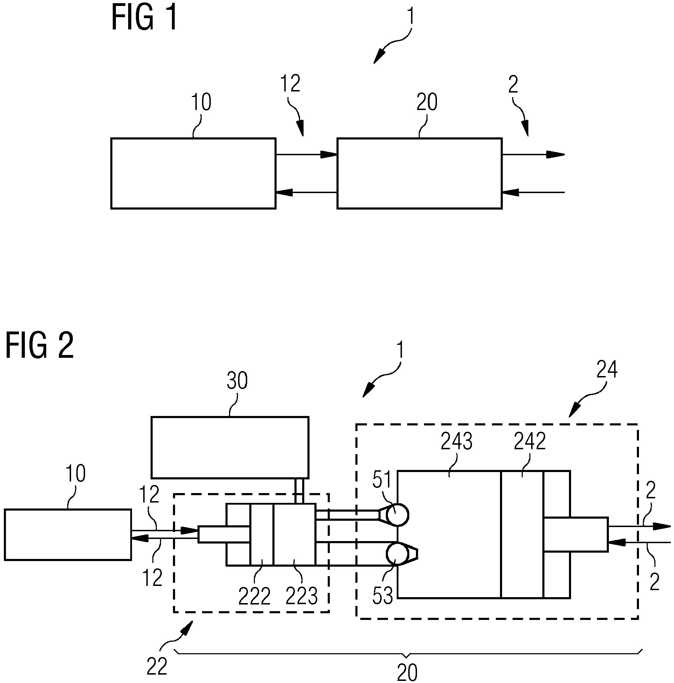

Figur 1 zeigt eine erfindungsgemäße Aktorvorrichtung 1 mit einem Polymeraktor 10 und einem verstärkenden Element 20. Der Polymeraktor 10 kann eine Kraft 12 auf das verstärkende Element 20 ausüben. Das verstärkende Element 20 kann die Kraft 12 verstärken. Die Kraft 12 kann von dem verstärkenden Element 20 derart umgewandelt werden, dass eine Bewegung 2 erzeugt wird. Dafür kann das verstärkende Element 20 beispielsweise hydraulisch ausgeführt sein. Das verstärkende Element 20 kann auch als Integratorelement bezeichnet werden, da es die Kraft 12 des Polymeraktors 10 aufsummieren kann. Der Polymeraktor 10 kann aus elektroaktivem Material bestehen. Elektroaktives Material ist in der Lage aufgrund eines elektrischen Signals, beispielsweise einer Spannung, eine Stauchung oder Dehnung zu erfahren.

Innerhalb des Polymeraktors 10 entstehen mehrere Deformationen in Folge eines elektrischen Signals. Folglich entsteht die Kraft 12. Das verstärkende Element 20 kann alle einzelnen Deformationen aufsummieren. Es entsteht eine Verstärkung der Kraft 12 und die Bewegung 2 wird erzeugt. Die Kraft 12 des Polymeraktors 10 wird auf das verstärkende Element 20 durch eine Bewegungskopplung übertragen. Dies bedeutet, das verstärkende Element 20 und der Polymeraktor 10 können mechanisch miteinander derart verbunden sein, dass die Übertragung der Kraft 12 ermöglicht wird. Es ist aber auch möglich, dass keine physische Verbindung zwischen dem Polymeraktor 10 und dem verstärkenden Element 20 besteht, sondern, dass durch den vorher beschriebenen Vorgang der Streckung oder Stauchung des elektroaktiven Materials des Polymeraktors 10 erst eine Verbindung zwischen dem Polymeraktor 10 und dem verstärkenden Element 20 entsteht.

Figur 2 zeigt eine schematische Darstellung einer Aktorvorrichtung gemäß einer Ausführungsform der Erfindung. Sie umfasst den Polymeraktor 10 und das verstärkende Element 20, welches in dieser Ausführungsform hydraulisch ausgestaltet ist. Das verstärkende Element 20 besteht aus einer ersten Kammer 22 und einer zweiten Kammer 24. Die erste Kammer 22 ist als Antriebszylinder ausgebildet. Der Antriebszylinder 22 besteht aus einem ersten Kolbenelement 222 und einem ersten Arbeitsraum 223. Die zweite Kammer 24 ist als ein Abtriebszylinder ausgebildet und besteht aus einem zweiten Kolbenelement 242 und einem zweiten Arbeitsraum 243. Die Kolbenelemente 222 und 242 sind in den jeweiligen Arbeitsräumen 223 und 243 jeweils beweglich gelagert. Dies ermöglicht, dass das erste Kolbenelement 222 das Volumen des ersten Arbeitsraums 223 antriebsseitig verändern und das Volumen des zweiten Arbeitsraums 243 das zweite Kolbenelement 242 abtriebsseitig bewegen kann. Dabei sind die Arbeitsräume 223 und 243 über ein erstes Rückschlagventil 51 miteinander verbunden. Das erste Rückschlagventil 51 öffnet bei hinreichend hohem Öffnungsdruck in die Richtung des zweiten Arbeitsraums 243. Die beiden Arbeitsräume 223 und 243 können zusätzlich über ein zweites Rückschlagventil 53 verbunden sein, welches bei hinreichend hohem Öffnungsdruck in Richtung des ersten Arbeitsraums 223 öffnet. Die Rückschlagventile 51 und 53 sind entsprechend einem bestimmten Öffnungsdruck vorgespannt. Der erste Arbeitsraum 223 kann außerdem mit einem Reservoir 30 für ein hydraulisches Arbeitsfluid verbunden sein. Die Arbeitsräume 223 und 243 der ersten und zweiten Kammer 22 und 24 sind mit dem hydraulischen Arbeitsfluid in bekannter Weise gefüllt.

Der Polymeraktor 10 kann das verstärkende Element 20 bzw. das erste Kolbenelement 222 betätigen, indem der Polymeraktor 10 die Kraft 12 auf das erste Kolbenelement 222, genauer auf eine länglich dargestellte Kolbenstange des ersten Kolbenelements 222, übertragen kann. Anschließend kann das erste Kolbenelement 222 die Kraft 12 hydraulisch auf das zweite Kolbenelement 242 übertragen. Dadurch wird die Kraft 12 verstärkt und die Bewegung 2 erzeugt. Eine Kolbenstange des zweiten Kolbenelements 242 kann anschließend mit einem zu bewegenden Element bewegungsgekoppelt sein und die erzeugte Bewegung 2 darauf übertragen.

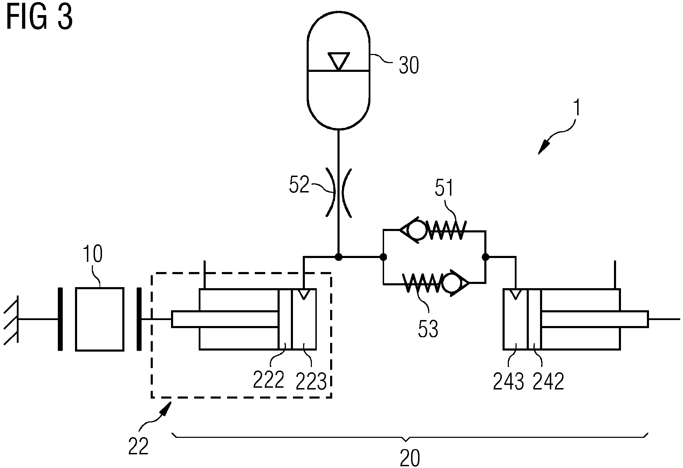

Um eine Bewegung nach rechts in Richtung des oberen Pfeiles der erzeugten Bewegung 2 zu bewirken, wird der Polymeraktor 10 wie folgt angesteuert. In einer ersten Bewegungsphase wird der Polymeraktor 10 dabei schnell in Richtung des oberen Pfeiles der Kraft 12 bewegt. Die Bewegung überträgt sich auf das erste Kolbenelement 222, wobei der hierdurch erzeugte Druck im ersten Arbeitsraum 223 die Schließkraft des Rückschlagventils 51 übersteigt, sodass das hydraulische Arbeitsfluid vom ersten Arbeitsraum 223 in den zweiten Arbeitsraum 243 übertritt und dort eine Kraft auf das zweite Kolbenelement 242 auswirkt, so dass sich dieser in Richtung des oberen Pfeils der Bewegung 2 bewegt. In einer zweiten Bewegungsphase wird der Polymeraktor 10 in Richtung des unteren Pfeiles der Kraft 12 zurückgezogen, was jedoch deutlich langsamer erfolgt als die erste Bewegungsphase. Hierdurch bewegt sich das erste Kolbenelement 222 ebenfalls in Richtung des unteren Pfeiles der Kraft 12, durch die langsame Bewegung wird jedoch die Schließkraft des Rückschlagventils 53 nicht überschritten. Es tritt also kein hydraulisches Arbeitsfluid aus dem zweiten Arbeitsraum 243 in den ersten Arbeitsraum 223 über, das zweite Kolbenelement 242 hält seine Position. Die Volumenänderung des ersten Arbeitsraums 223 durch die Bewegung des ersten Kolbenelements 222 wird durch hydraulisches Arbeitsfluid ausgeglichen, welches aus dem Reservoir 30 durch eine Leitung und eine Drossel 52, welche in FIG 3 symbolisch dargestellt ist, in den ersten Arbeitsraum 223 strömt.

Durch alternierende Wiederholung der beiden Bewegungsphasen kann somit das zweite Kolbenelement 242 weiter vorgeschoben werden als durch die Bewegungsreichweite des Polymeraktors 10 vorgegeben. Die Übersetzung zwischen den Kolbenelementen 222 und 243 ermöglicht dabei eine Positionierung des zweiten Kolbenelements 242 mit besonders hoher Präzision, wobei vorteilhafterweise zum Halten des Kolbenelements 242 in Position keine Kraft aufgewendet werden muss.

Soll das Kolbenelement 242 in Gegenrichtung, also in Richtung des unteren Pfeiles der Bewegung 2 zurückgezogen werden, so werden die beiden Bewegungsphasen umgekehrt. Zunächst wird also der Polymeraktor 10 schnell in Richtung des unteren Pfeiles der Kraft 2 bewegt, so dass die resultierende Druckänderung im ersten Arbeitsraum 223 die Schließkraft des Rückschlagventils 53 überschreitet und hydraulisches Arbeitsfluid aus dem zweiten Arbeitsraum 243 in den ersten Arbeitsraum 223 überströmen kann, wodurch sich das zweite Kolbenelement 242 in Richtung des unteren Pfeiles der Bewegung 2 bewegt. In der zweiten Bewegungsphase wird der Polymeraktor 10 langsam in Richtung des unteren Pfeiles der Bewegung 2 bewegt, wodurch wiederum die Schließkraft Rückschlagventils 51 nicht überschritten wird, sodass das zweite Kolbenelement 242 seine Position hält und hydraulisches Arbeitsfluid aus dem ersten Arbeitsraum 223 über die Drossel 52 ins Reservoir 30 zurückströmt. Auch hier kann durch alternierendes Wiederholen der beiden Bewegungsphasen eine weitere Bewegung des Kolbenelements 243 erzeugt werden.

Figur 3 zeigt ein hydraulisches Ersatzschaltbild der Aktorvorrichtung gemäß Figur 2. Hierfür sind die bekannten Symbole beispielsweise für Drosseln und Ventile entsprechend dargestellt.

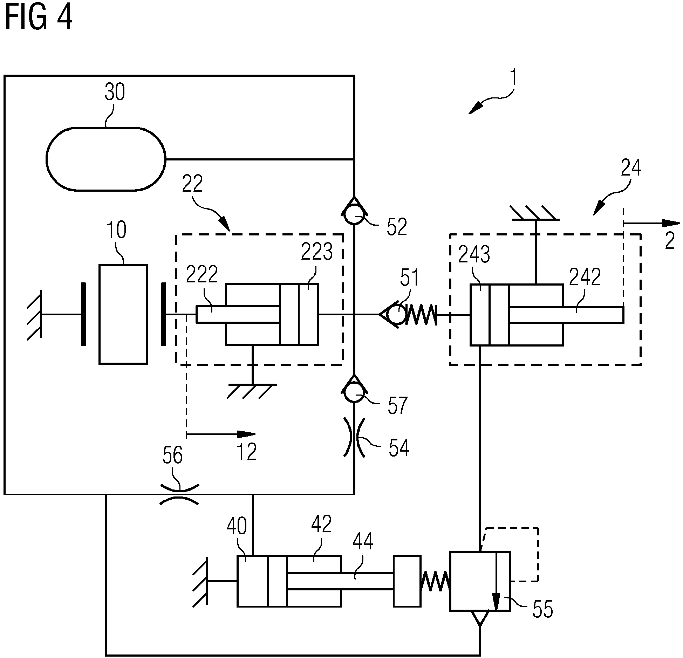

Figur 4 zeigt ein weiteres hydraulisches Ersatzschaltbild der Aktorvorrichtung. In dieser Ausführungsform ist das Volumen des ersten Arbeitsraumes 223 über ein Rückschlagventil 52 anstatt der Drossel 52 speisbar mit dem Reservoir 30 gekoppelt. Darüber hinaus kann das (Antriebs-)Volumen des ersten Arbeitsraums 223 über ein drittes Rückschlagventil 57 und eine in Durchlassrichtung hinter dem Rückschlagventil 57 angeordnete Drossel 54 ein Vorspannvolumen 40 eines hydraulischen Vorspannzylinders 42 speisen, welche mittels eines Vorspannkolbens 44 ein Druckbegrenzungsventil 55 steuert. Über eine dritte Drossel 56 ist das Vorspannvolumen 40 an das Reservoir 30 gekoppelt. Das Druckbegrenzungsventil 55 druckbegrenzt oder druckentlastet das (Abtriebs-)Volumen des zweiten Arbeitsraumes 243 in das oder gegenüber dem Reservoir 30.

Die in Figur 4 dargestellte Aktorvorrichtung 1 wird wie nachfolgend beschrieben betrieben. Die Begriffe "erster Betriebsmodus" und "zweiter Betriebsmodus" wiederholen sich hier, sollen aber nachfolgend für die Ausführungsform der Aktorvorrichtung 1 aus Figur 4 dienen. Die einzelnen Betriebsmodi sind durch die Ansteuerung des Polymeraktors 10 charakterisiert. In einem ersten Betriebsmodus wird der Polymeraktor mit einer geringen Systemsteifigkeit betrieben und mit einer von Null verschiedenen Stellgeschwindigkeit gestellt. Dazu wird der Polymeraktor 10 schnell ausgelenkt (d.h., der Stellweg steigt mit hoher Steigung mit der Zeit an). Somit steigt der Druck im ersten Arbeitsraum 223 des Antriebszylinders 22, sodass sich das das Volumen des ersten Arbeitsraums 223 mit dem Volumen des zweiten Arbeitsraums 243 koppelnde Rückschlagventil 51 und das das Volumen des ersten Arbeitsraums 223 mit dem Vorspannvolumen 40 koppelnde Rückschlagventil 57 öffnen. Da in diesem ersten Betriebsmodus die Auslenkung des Polymeraktors 10 und somit der Druckanstieg im ersten Arbeitsraum 223 nur sehr kurz ist, kann durch das Rückschlagventil 57 aufgrund der seriell verbauten Drossel 54 annähernd kein hydraulisches Arbeitsfluid in Richtung Vorspannvolumen 40 fließen, wobei dieser geringe Fluss von hydraulischem Arbeitsfluid wieder über die das Vorspannvolumen 40 mit dem Reservoir 30 koppelnden Drossel 56 ins Reservoir 30 abfließt. Somit baut sich im Vorspannvolumen 40 nahezu kein Druck auf. Folglich fließt das hydraulische Arbeitsfluid fast ausschließlich in den zweiten Arbeitsraum 243, sodass das zweite Kolbenelement 242 mit einem resultierenden Stellweg in Richtung des Pfeiles der erzeugenden Bewegung 2 der Aktorvorrichtung 1 ausgetrieben wird.

Anschließend wird die Auslenkung des Polymeraktors 10 wieder schlagartig (große negative Steigung des Stellwegs) verringert, wodurch das Antriebsvolumen des ersten Arbeitsraumes 223 mit dem Abtriebsvolumen des zweiten Arbeitsraumes 243 koppelnde Rückschlagventil 51 und das das Antriebsvolumen des ersten Arbeitsraumes 223 mit dem Vorspannvolumen 40 koppelnde Rückschlagventil 57 schließen. Aufgrund des verringerten hydraulischen Arbeitsfluids im Antriebsvolumen des ersten Arbeitsraumes 223 entsteht Unterdruck, wodurch sich das das Antriebsvolumen des ersten Arbeitsraumes 223 mit dem Reservoir 30 koppelnde Rückschlagventil 52 öffnet und das fehlende hydraulische Arbeitsfluid vom Reservoir 30 in das Antriebsvolumen des ersten Arbeitsraumes 223 fließen kann.

Wird im ersten Betriebsmodus dieser Zyklus - d.h. schnelles Auslenken und Rückstellen des Polymeraktors 10 - wiederholt, erfolgt eine kontinuierliche Auslenkung des zweiten Kolbenelements 242. Wirkt auf das zweite Kolbenelement 242 eine Gegenkraft ein, so erhöht sich gemäß dieser Gegenkraft und des hydraulischen Querschnitts des zweiten Kolbenelements 242 der Druck im zweiten Arbeitsraum 243. Da die Schwelle im Druckbegrenzungsventil 55 aufgrund des fehlenden Druckes im Vorspannvolumen 40 sehr gering ist, fließt hydraulisches Arbeitsfluid schon bei einer geringen Gegenkraft auf das zweiten Kolbenelement 242 vom zweiten Arbeitsraum 243 über das Druckbegrenzungsventil 55 in das Reservoir 30 zurück.

In einem zweiten Betriebsmodus wird die Aktorvorrichtung 1 mit einer hohen Systemsteifigkeit betrieben und mit einer von Null verschiedenen Stellgeschwindigkeit gestellt. Dazu wird der Polymeraktor 10 wie zuvor beschrieben schnell ausgelenkt (d.h., der Stellweg steigt wiederum mit hoher Steigung mit der Zeit an). Demgemäß steigt der Druck im Volumen des ersten Arbeitsraums 223 an und das den ersten Arbeitsraum 223 mit dem zweiten Arbeitsraum 243 koppelnde Rückschlagventil 51 und das den zweiten Arbeitsraum 243 mit dem Vorspannvolumen 40 koppelnde Rückschlagventil 57 öffnen. Durch das Abfließen des hydraulischen Arbeitsfluids in den zweiten Arbeitsraum 243 sinkt der Druck im Volumen des ersten Arbeitsraums 223 wie im zuvor beschriebenen Betriebsmodus.

Im Gegensatz zum vorherigen Betriebsmodus wird die Auslenkung des Polymeraktors 10 hier für eine bestimmte Zeit konstant gehalten. Da das das Volumen des ersten Arbeitsraums 223 mit dem Volumen des zweiten Arbeitsraums 243 koppelnde Rückschlagventil 51 einen definierten Öffnungsdruck hat, schließt es, wenn die Druckdifferenz zwischen ersten Arbeitsraum 223 und zweiten Arbeitsraum 243 kleiner als der Öffnungsdruck des Rückschlagventils 51 ist. Da der Polymeraktor 10 immer noch ausgelenkt ist, liegt am den ersten Arbeitsraum 223 mit den Vorspannvolumen 40 koppelnden Rückschlagventil 57 der verbleibende Druck an. Da das den ersten Arbeitsraum 223 mit den Vorspannvolumen 40 koppelnde Rückschlagventil 57 nicht vorgespannt ist, kann hydraulisches Arbeitsfluid über dieses Rückschlagventil 57 und die diesem Rückschlagventil 57 flussabwärts angeordnete Drossel 54 solange fließen bis die Druckdifferenz zwischen Vorspannvolumen 40 und ersten Arbeitsraum 223 größer ist. Obwohl ein kleiner Teil hydraulisches Arbeitsfluid wieder über die das Vorspannvolumen 40 mit dem Reservoir 30 koppelnde Drossel 56 ins Reservoir 30 zurückfließt, steigt der Druck im Vorspannvolumen 40 an. Dadurch wird die Öffnungsschwelle im Druckbegrenzungsventil 55 erhöht. Nach einer bestimmten Zeit wird der Polymeraktor 10 wieder schlagartig auf dessen ursprünglichen Stellweg rückgestellt (große negative Steigung). Dadurch wird wie beim zuvor beschriebenen ersten Betriebsmodus hydraulisches Arbeitsfluid 3 vom Reservoir 55 in das Antriebsvolumen 25 gesaugt. Wäre die das Vorspannvolumen 60 mit dem Reservoir 55 koppelnde Drossel 85 nicht verbaut, so würde hydraulisches Arbeitsfluid 3 nicht nur aus dem Reservoir 30 sondern auch aus dem Vorspannvolumen 40 gesaugt werden.

Anschließend wird der beschriebene Zyklus - Auslenken und Rückstellen des Polymeraktors 10 - wiederholt. Wirkt in diesem Fall auf das zweite Kolbenelement 242 eine Gegenkraft ein, so erhöht sich wieder der Druck in dem zweiten Arbeitsraum 243. Allerdings ist die Schwelle im Druckbegrenzungsventil 55 aufgrund des erhöhten Drucks im Vorspannvolumen 40 größer als im vorhergehend beschriebenen Betriebsmodus, wodurch eine höhere Kraft auf das erste Kolbenelement 222 aufgebaut werden kann und ein Abfließen von hydraulischem Arbeitsfluid 3 aus dem zweiten Arbeitsraum 243 verringert ist. Dadurch erhöht sich die Systemsteifigkeit der Aktorvorrichtung 1. Die Höhe dieser Steifigkeit wird somit über das Ansteuerungsprofil des Polymeraktors 10 eingestellt.

In einem dritten Betriebsmodus wird die Aktorvorrichtung 1 mit einer hohen Systemsteifigkeit betrieben und nicht gestellt(d.h. mit einer Stellgeschwindigkeit gleich Null gestellt). Dazu wird der Polymeraktor 10 langsam ausgelenkt (vergleichsweise geringe Steigung) und der Druck im Volumen des ersten Arbeitsraums 223 steigt kaum an, wodurch sich nur das den ersten Arbeitsraum 223 mit dem Vorspannvolumen 40 koppelnde Rückschlagventil 57 öffnet, nicht aber das den ersten Arbeitsraum 223 mit dem zweiten Arbeitsraum 243 koppelnde Rückschlagventil 51. Dadurch wird kein hydraulisches Arbeitsfluid 3 in den zweiten Arbeitsraum 243, sondern nur in das Vorspannvolumen 40 gepumpt, wodurch die Schwelle des Druckbegrenzungsventils 55 und somit die Systemsteifigkeit der Aktorvorrichtung 1 ansteigt ohne dass sich das zweite Kolbenelement 242 auslenkt. Nach einer bestimmten Zeit wird der Polymeraktor 10 wieder schlagartig auf dessen ursprünglichen Stellweg rückgestellt (große negative Steigung).

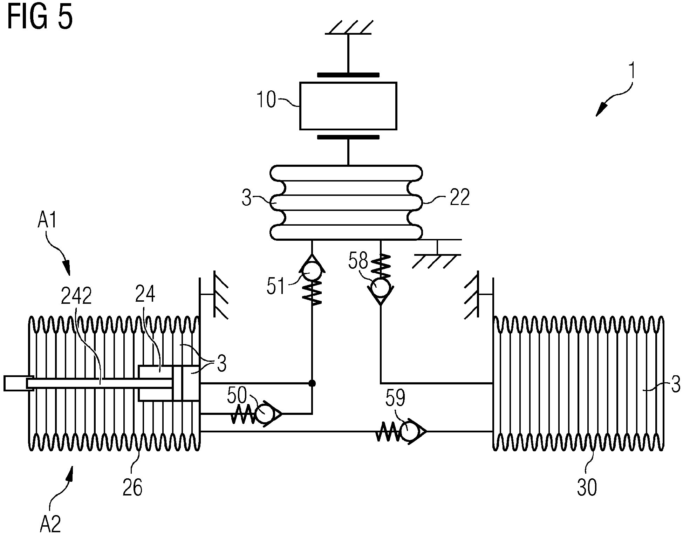

Figur 5 zeigt ein weiteres Ausführungsbeispiel einer erfindungsgemäßen Aktorvorrichtung 1 und das erfindungsgemäße Konzept. Als antreibendes Element wird auch in dieser Ausführungsform der Polymeraktor 10 verwendet, der mit dem verstärkenden Element 20 gekoppelt ist. Das verstärkende Element 20 weist in diesem Ausführungsbeispiel vier Kammern auf. Und zwar eine erste Kammer 22 als Antrieb, eine zweite Kammer 24, eine dritte Kammer 26, welche als ein mit einem hydraulischen Arbeitsfluid 3 gefüllter Abtriebsbalg ausgebildet ist, und eine vierte Kammer 30, welche als ein Reservoir 30 ausgebildet ist. Ein erster Abtrieb 1 (A1) ist in diesem Fall die zweite Kammer 24, welche als ein Hydraulikzylinder 24 ausgeführt und sowohl an dessen Gehäuse als auch an einem zweiten Kolbenelement 242 mit einem parallel geschalteten Abtrieb 2 (A2) mechanisch fest verbunden ist. Der zweite Abtrieb 2 (A2) ist ein mit dem hydraulischen Arbeitsfluid 3 gefüllter und die dritte Kammer 26 bildender Abtriebsbalg, der mit dem zweiten Kolbenelement 242 und dem Gehäuse der zweiten Kammer 24 mechanisch parallel gekoppelt ist. Der Abtrieb 1 (A1) hat eine kleinere hydraulische Querschnittsfläche als der Abtrieb 2 (A2) und gegebenenfalls als der Antrieb 22. Zum Ansteuern der Aktovorrichtung 1 wird eine Spannung in Pulsweitenmodulation - (PWM) - Form angelegt. Infolge des Spannungsanstiegs des PWM-Signals dehnt sich der Polymeraktor 1 aus, wodurch das hydraulische Arbeitsfluid 3 im Antrieb 22 komprimiert wird und der Druck aufgrund der Quasi-Inkompressibilität steigt. Dadurch öffnet sich das Rückschlagventil 51, sodass hydraulisches Arbeitsfluid 3, beispielsweise Hydrauliköl, vom Antrieb 22 in den Abtrieb A1, also in den Hydraulikzylinder 24 fließt. Mit kleinerem Querschnitt von Abtrieb A1 im Vergleich zum Antrieb 22 erfolgt eine Übersetzung des Hubs des Polymeraktors 10. Als Nächstes wird die PWM-Spannung an dem Polymeraktor 10 wieder auf null gesetzt, wodurch sich der Druck im Antrieb 22 verringert und aufgrund der Volumenreduktion des hydraulischen Arbeitsfluids 3 ergibt sich ein Unterdruck (dabei wurde zuvor ein Teil des im Antrieb 22 vorhandenen hydraulischen Arbeitsfluids 3 in den Abtrieb A1 gepumpt). In Folge des Unterdrucks öffnet das Rückschlagventil 58 und hydraulisches Arbeitsfluid 3 wird vom Reservoir 30 in den Antrieb 22 gesaugt. Danach kann die PWM-Spannung wieder erhöht werden und der zuvor beschriebene Zyklus wiederholt werden. Durch die Wiederholung wird stufenweise hydraulisches Arbeitsfluid 3 vom Reservoir 30 über den Antrieb 22 in den Abtrieb A1 gepumpt. In Folge der Auslenkung des zweiten Kolbenelements 242, also des Abtriebs A1, wird ebenso der Abtrieb A2 ausgelenkt, da beide mechanisch miteinander gekoppelt sind. Das zweite Kolbenelement 242 kann am linken Ende, wie in FIG 5 dargestellt, eine Befestigungsstelle aufweisen, an der ein Abtriebsbalg 26 mit dem zweiten Kolbenelement 242 mechanisch verbunden ist. Da in dem Abtrieb A2 kein hydraulisches Arbeitsfluid 3 aktiv gepumpt wird, würde Unterdruck entstehen, da die Fluidmenge trotz steigendem Volumen des zweiten Abtriebs A2 konstant bleibt. Dadurch würde eine Gegenkraft am Abtrieb A1 entstehen, wodurch die Auslenkung des Abtriebs A1 blockiert werden würde. Aus diesem Grunde wird eine hydraulische Verbindung zwischen Abtrieb A2 und Reservoir 30 geschaffen, die das Rückschlagventil 59 aufweist. Dieses Rückschlagventil 59 öffnet sich, wenn in Folge des Pumpens des hydraulischen Arbeitsfluids 3 in den Abtrieb A1 ein Unterdruck in dem zweiten Abtrieb A2 entsteht. Dadurch wird auf passive Weise dafür gesorgt, dass der zweite Abtrieb A2 lediglich einen geringen Einfluss auf die Expansion von dem ersten Abtrieb A1 hat.

Sobald der erste Abtrieb A1 gegen eine Gegenkraft, beispielsweise in Folge eines Hindernisses, bewegt wird oder fährt, ist für den Aktor 1 zum Betrieb erforderlich, dass viel Kraft aufgebaut wird. Dies ist allerdings mit dem ersten Abtrieb A1 lediglich bedingt möglich, da die hydraulische Querschnittsfläche zu klein gewählt wurde, um eine große Geschwindigkeitsübersetzung bereit zu stellen. Je kleiner die hydraulische Fläche des ersten Abtriebs A1 ist, desto kleiner ist die Abtriebskraft bei einem maximalen Druck im ersten Abtrieb A1. Aus diesem Grund ist zwischen dem ersten Abtrieb A1 und dem zweiten Abtrieb A2 ein Rückschlagventil 50 verbaut. Steigt der Druck im ersten Abtrieb A1 aufgrund einer Gegenkraft, öffnet sich das Rückschlagventil 50, wodurch das hydraulische Arbeitsfluid 3 zusätzlich zu dem ersten Abtrieb A1 ebenso den zweiten Abtrieb A2 in diesen gepumpt wird. Da bei dem zweiten Abtrieb A2 der hydraulische Querschnitt deutlich größer ist, steigt im Vergleich zu dem ersten Abtrieb A1 bei gleichem Druck die vom zweiten Abtrieb A2 bereit gestellte Abtriebskraft.

Das Zurückziehen des ersten und des zweiten Abtriebs A1 und A2 erfolgt gemäß diesem Konzept mittels einer eingebauten Leckage. Gemäß Figur 5 kann das dritte Rückschlagventil 59 mit einer einfachen Leckage bereit gestellt sein, sodass das hydraulische Arbeitsfluid 3 langsam vom zweiten Abtrieb A2 zum Reservoir 30 zurückdriftet.

## Patentansprüche

1. Eine Aktorvorrichtung (1), aufweisend:
a. einen Polymeraktor (10),
b. ein Element (20), wobei
c. der Polymeraktor (10) mit dem Element (20) bewegungsgekoppelt ist, wobei
d. das Element (20)
- zur Übersetzung einer Kraft (12) oder einer anderen Größe, oder
- Aufintegrieren mindestens zweier Bewegungen eingerichtet ist.

2. Die Aktorvorrichtung (1) nach Anspruch 1, wobei das Element (20) hydraulisch ausgebildet ist.

3. Die Aktorvorrichtung (1) nach Anspruch 2, wobei das Element (20)
a. mindestens eine erste Kammer (22), und
b. mindestens eine zweite Kammer (24) aufweist,
wobei die erste und die zweite Kammer (22, 24) jeweils mindestens zum Teil fluidisch mit einem hydraulischen Arbeitsfluid (3) miteinander gekoppelt sind.

4. Die Aktorvorrichtung (1) nach Anspruch 3, wobei
a. die mindestens eine erste Kammer (22) als ein Antriebszylinder eingerichtet ist, aufweisend ein erstes Kolbenelement (222) und einen ersten Arbeitsraum (223), wobei ein erstes Volumen (224) des ersten Arbeitsraums (223) durch Bewegen des mindestens einen ersten Kolbenelementes (222) änderbar ist,
b. die mindestens zweite Kammer (24) als ein Abtriebszylinder eingerichtet ist, aufweisend ein zweites Kolbenelement (242) zum Erzeugen der Bewegung und einen zweiten Arbeitsraum (243), wobei ein zweites Volumen (244) des zweiten Arbeitsraums (243) durch Bewegen des mindestens einen zweiten Kolbenelementes (242) änderbar ist,
c. der Polymeraktor (10) zum Ausüben der Kraft (12) auf die mindestens eine erste Kammer (22) ausgebildet ist.

5. Die Aktorvorrichtung (1) nach Anspruch 4, wobei der mindestens eine erste und der mindestens eine zweite Arbeitsraum (223, 243) über mindestens ein erstes Rückschlagventil (51) verbunden sind.

6. Die Aktorvorrichtung (1) nach Anspruch 5, wobei der erste und der zweite Arbeitsraum (223, 243) über zwei Rückschlagventile (51, 53) verbunden sind, wobei ein Rückschlagventil (51, 53) gegenläufig zu dem anderen Rückschlagventil (51, 53) ausgerichtet ist.

7. Die Aktorvorrichtung (1) nach einem der Ansprüche 4 bis 6, wobei der erste Arbeitsraum (223) des ersten Kolbenelements (222) über eine erste Drossel (52) mit einem Reservoir (30) für das hydraulische Arbeitsfluid (3) des Elements (20) gekoppelt ist.

8. Die Aktorvorrichtung (1) nach einem der Ansprüche 4 bis 7, das Element (20) weiterhin aufweisend ein Druckbegrenzungsventil (55), welches dazu eingerichtet ist abhängig von einer Einwirkzeit der Kraft (12) auf den Antriebszylinder (22) und/oder auf das erste Kolbenelement (222) den Abtriebszylinder (24) druckbegrenzt.

9. Die Aktorvorrichtung (1) nach Anspruch 8, wobei der erste Arbeitsraum (223) des Antriebsbszylinder (22) über mindestens ein drittes Rückschlagventil (57) und eine zweite Drossel (54) hydraulisch an ein Vorspannvolumen (40) gekoppelt ist, welches insbesondere in einem Vorspannhydraulikzylinder (42) befindlich ist, wobei der Vorspannhydraulikzylinder (42) oder der Vorspannkolben (44) das Druckbegrenzungsventil (55) stellt.

10. Die Aktorvorrichtung (1) nach Anspruch 9, wobei das Vorspannvolumen (40) über eine dritte Drossel (56) hydraulisch mit dem Reservoir (30) verbunden ist.

11. Die Aktorvorrichtung (1) nach Anspruch 9, wobei das Druckbegrenzungsventil (55) zur Druckbegrenzung gegenüber dem Reservoir (30) oder zur Druckentlastung in dem Reservoir (30) angeordnet ist.

12. Die Aktorvorrichtung (1) nach Anspruch 3, wobei
a. die erste Kammer (22) ein von dem Polymeraktor (2) bewegbarer und mit einem hydraulischen Arbeitsfluid (3) gefüllter Antriebsbalg ist,
a. die zweite Kammer (24) als ein Abtriebszylinder mit einem zweiten Kolbenelement (242) und mit einem zweiten Arbeitsraum (243) ausgeführt ist, und wobei der Abtriebszylinder (24) mit dem Antriebsbalg (22) über ein erstes Rückschlagventil (51) einen ersten Abtrieb (A1) bildend hydraulisch verbunden ist,
b. ein mit dem hydraulischen Arbeitsfluid (3) gefüllter und eine dritte Kammer (26) bildender Abtriebsbalg mit dem zweiten Kolbenelement (242) und dem Gehäuse der zweiten Kammer (24) einen zweiten Abtrieb (A2) bildend mechanisch parallel gekoppelt ist,
d. der Antriebsbalg (22) über ein zweites Rückschlagventil (58) hydraulisch mit einer mit dem hydraulischen Arbeitsfluid (3) gefüllten vierten Kammer (28) als Hydraulikreservoir ausgebildet verbunden ist,
d. das Hydraulikreservoir (28) mit dem Abtriebsbalg (26) über ein drittes Rückschlagventil (59) hydraulisch verbunden ist, und
e. der Abtriebszylinder (24) mit dem Abtriebsbalg (26) über ein viertes Rückschlagventil (50) hydraulisch verbunden ist.

13. Die Aktorvorrichtung (1) nach Anspruch 11, wobei der hydraulische Querschnitt des zweiten Kolbenelements (242) kleiner als der hydraulische Querschnitt des Abtriebsbalgs (26) und kleiner als der hydraulische Querschnitt des Antriebsbalgs (22) ist.

14. Die Aktorvorrichtung (1) nach Anspruch 12, wobei das vierte Rückschlagventil (59) derart eingerichtet ist, dass es bei einem Druckanstieg im ersten Abtrieb (A1) infolge einer äußeren Gegenkraft derart öffnet, dass Hydraulikflüssigkeit (3) zusätzlich zum zweiten Abtrieb (A2) befördert wird.

15. Die Aktorvorrichtung (1) nach einem der vorhergehenden Ansprüche, wobei die Ventile (50,51,53,55,57,58,59) oder die Drosseln (52,54,56) aus einem Polymer ausgebildet sind.
